# FASCICULE DE BREVET EUROPEEN

(11) **EP 0 673 061 B1**
(45) Date de publication et mention de la délivrance du brevet: **11.09.2002**
(21) Numéro de dépôt: 95400514.6
(22) Date de dépôt: 10.03.1995
(51) Int. Cl.: H01L 21/76

(54) **Procédé d'isolement de zones actives d'un substrat semi-conducteur par tranchées peu profondes, notamment étroites**
Verfahren zur Isolierung activer Zonen in einem Halbleitersubstrat mittels untiefen, nicht breiten Graben
Isolation method for active regions in a semiconductor substrate using shallow trenches, especially not large

(30) Priorité: 11.03.1994 FR 9402870
(43) Date de publication de la demande: 20.09.1995
(73) Titulaire: FRANCE TELECOM, 75015 Paris (FR)
(72) Inventeur: Paoli, Maryse, F-38190 Villard Bonot (FR); Brouquet, Pierre, F-38920 Crolles (FR); Haond, Michel, F-38240 Meylan (FR)
(74) Mandataire: Casalonga, Axel

(56) Documents cités:
- EP-A- 0 300 569
- EP-A- 0 407 047
- EP-A- 0 461 498
- JP-A- 5 013 566
- US-A- 4 952 524
- PATENT ABSTRACTS OF JAPAN vol. 9 no. 39 (E-297) [1762] ,19 Février 1985 & JP-A-59 181640 (FUJITSU LTD) 16 Octobre 1984,
- PATENT ABSTRACTS OF JAPAN vol. 18 no. 105 (E-1512) ,21 Février 1994 & JP-A-05 304219 (KAWASAKI STEEL CORP.) 16 Novembre 1993,
- IEEE TRANSACTIONS ON ELECTRON DEVICES, vol. ED-34, no. 12, Décembre 1987 NEW YORK US, pages 2450-2455, G.H KAWAMOTO ET AL. 'HOT-ELECTRON TRAPPING IN THIN LPCVD SiO2 DIELECTRICS'

## Description

L'invention concerne l'isolement latéral de zones actives d'un substrat semi-conducteur par tranchées peu profondes.

Dans le cadre de la réduction des dimensions et de l'augmentation de densité dans le domaine de la microélectronique, les techniques d'isolement latéral évoluent. L'homme du métier connaît déjà les techniques à base d'oxydation localisée connues sous la dénomination "LOCOS". Selon une telle technique, on procède à une croissance thermique d'oxyde dans une ouverture destinée à former la structure isolante. Toutefois, l'homme du métier sait qu'une telle structure s'étend latéralement selon une forme appelée "bec d'oiseau" provoquant un élargissement de la zone d'isolement et un rétrécissement de la zone active. Au prix de nombreuses manipulations techniques, on parvient à obtenir aujourd'hui une diminution de la longueur du bec d'oiseau. Cependant, cette technique présente des limites qui s'avèrent actuellement infranchissables car elle conduit à un amincissement de l'oxyde isolant dans des ouvertures étroites.

EP-A-O 461 498, JP-A-5 304 219, JP-A-59 181 640, US-A-952 524, EP-A-0 407 047 et JP-A-05 013 566 décrient techniques d'isolement connues par l'homme du métier.

L'homme du métier connaît par ailleurs une autre technique d'isolation qui consiste en le remplissage de tranchées peu profondes par un matériau isolant. Une telle technique est communément appelée en langue anglaise par l'homme du métier "BOX" ou "Shallow Trench Isolation (STT)". Cette technique, qui a fait l'objet de nombreuses recherches et publications depuis de nombreuses années a connu un développement très limité jusqu'à ce jour du fait de sa complexité technologique.

L'invention a pour but de proposer un procédé selon la revendication 1.

L'isolation de zones actives de substrat semi-conducteur par tranchées latérales selon l'invention, assure une bonne isolation électrique ainsi qu'un bon remplissage des tranchées, notamment dans le cas de tranchées particulièrement étroites dont le rapport profondeur/largeur peut être supérieur à 1 avec une largeur de l'ordre de 0,4 µm voire moins, par exemple 0,2 µm.

Selon une caractéristique générale du procédé d'isolement de zones actives d'un substrat semi-conducteur par tranchées latérales selon l'invention,
a) on réalise au sein du substrat semi-conducteur des tranchées disposées latéralement par rapport à des régions prédéterminées de substrat destinées à former ultérieurement lesdites zones actives,
b) on dépose, dans les tranchées et sur lesdites régions prédéterminées de substrat, un empilement comportant une couche d'un premier oxyde isolant dit d'aplanissement disposée entre deux couches d'un deuxième oxyde isolant dit conforme,
c) on effectue un recuit de densification du bloc semi-conducteur formé à l'étape b), et,
d) on effectue une étape d'aplanissement du bloc semi-conducteur recuit de façon à découvrir la surface supérieure desdites régions prédéterminées de substrat et à laisser subsister dans les tranchées isolantes de l'oxyde conforme et de l'oxyde d'aplanissement.

Selon un mode de mise en oeuvre du procédé selon l'invention. dans l'étape b) on dépose, pour former ledit empilement, une première couche d'oxyde conforme ayant une épaisseur choisie en fonction de la dimension latérale minimale des tranchées, puis la couche d'oxyde d'aplanissement ayant une épaisseur choisie de façon à obtenir une variation de relief inférieure à un seuil prédéterminé pour les tranchées de dimension latérale minimale, et enfin, une deuxième couche d'oxyde conforme ayant une épaisseur choisie en fonction de la profondeur de tranchée.

On choisit de préférence une épaisseur de la première couche d'oxyde conforme comprise entre 1/4 et 1/3 de la dimension latérale minimale des tranchées, tandis que ledit seuil prédéterminé est choisi de préférence de l'ordre de 200 Å (10 Å = 1 nm).

L'épaisseur de la couche d'oxyde d'aplanissement est avantageusement comprise entre 1000 Å et 2000 Å.

Dans l'étape a) selon un mode de mise en oeuvre du procédé, on effectue préalablement à la réalisation des tranchées un dépôt d'une couche auxiliaire sur une couche primaire d'oxyde ou d'oxynitrure de silicium; l'épaisseur de la deuxième couche d'oxyde conforme de l'empilement est alors choisie avantageusement supérieure à la somme de l'épaisseur de ladite couche auxiliaire et de la profondeur de tranchée.

Selon un mode de mise en oeuvre préféré de l'invention, dans l'étape d) d'aplanissement,
d1) on effectue une gravure sélective partielle du bloc semi-conducteur recuit de façon à laisser subsister de part et d'autre de chaque région prédéterminée de substrat ou de part et d'autre de groupes de régions prédéterminées de substrat voisines, des zones saillantes d'oxyde conforme,
d2) on effectue un polissage mécano-chimique partiel de la couche supérieure d'oxyde conforme du bloc semi-conducteur formé à l'étape d1) de façon à réduire la hauteur des zones saillantes d'oxyde conforme en dessous d'une hauteur de relief résiduel choisie, par exemple 1000 Å,
d3) on découvre les régions prédéterminées de susbtrat à partir d'une gravure chimique avec détection de fin d'attaque, par exemple une gravure plasma, effectuée sur le bloc semi-conducteur formé à l'étape d2).

La détection de fin d'attaque s'effectue de préférence sur la couche auxiliaire agissant alors en temps que couche d'arrêt pour l'opération de gravure.

La hauteur de relief résiduel que ne doivent pas dépasser les zones saillantes d'oxyde conforme réduites après polissage mécano-chimique est choisie notamment pour ne pas perturber les étapes ultérieures de photolithographie qui interviennent jusqu'à réalisation finale du composant semi-conducteur implanté dans le substrat. Il a été observé qu'une hauteur résiduelle de 1000 Å était une limite acceptable.

Selon un mode de mise en oeuvre de l'invention, dans l'étape a) la définition des régions prédéterminées de substrat destinées à former ultérieurement les zones actives comporte la réalisation d'un masque tandis que la réalisation de certaines des régions saillantes s'effectue à partir d'un contre-masque correspondant au négatif du masque de définition des régions prédéterminées de substrat. Cependant, la réalisation de certaines autres régions saillantes peut s'effectuer à partir d'un contre-masque agrandi par rapport au négatif du masque de définition des zones actives. C'est le cas en particulier en présence de zones actives voisines les unes des autres et séparées par des tranchées étroites.

Alors que d'une façon générale selon l'invention, l'utilisation d'oxyde conforme et d'oxyde d'aplanissement permet de remplir les petites cavités, ayant typiquement un rapport profondeur/largeur de l'ordre de 1, cette utilisation de deux oxydes et notamment de l'oxyde d'aplanissement permet une tolérance pour l'alignement du contre-masque sur le substrat semi-conducteur ce qui permet d'éviter la formation de crevasses ultérieures de part et d'autre des régions actives ce qui provoquerait des courants de fuite dans le composant semi-conducteur final.

Selon un mode de réalisation préféré, le matériau isolant forme, de part et d'autre de ladite région déterminée découverte du substrat, une bosse sur la surface supérieure plane du dispositif, la hauteur de cette bosse étant avantageusement inférieure à 1000 Å.

D'autres avantages et caractéristiques de l'invention apparaîtront à l'examen de la description détaillée de modes de mise en oeuvre et de réalisation de l'invention, nullement limitatifs, et des dessins annexés sur lesquels :
- les figures 1a à 1i illustrent un mode de mise en oeuvre du procédé selon l'invention,
- les figures 2a à 2f illustrent un autre mode de mise en oeuvre du procédé selon l'invention plus particulièrement destiné aux zones actives voisines espacées de tranchées étroites, et,
- les figures 3a et 3b illustrent respectivement une région de substrat recouverte par une couche d'oxyde conforme et par une couche d'oxyde d'aplanissement.

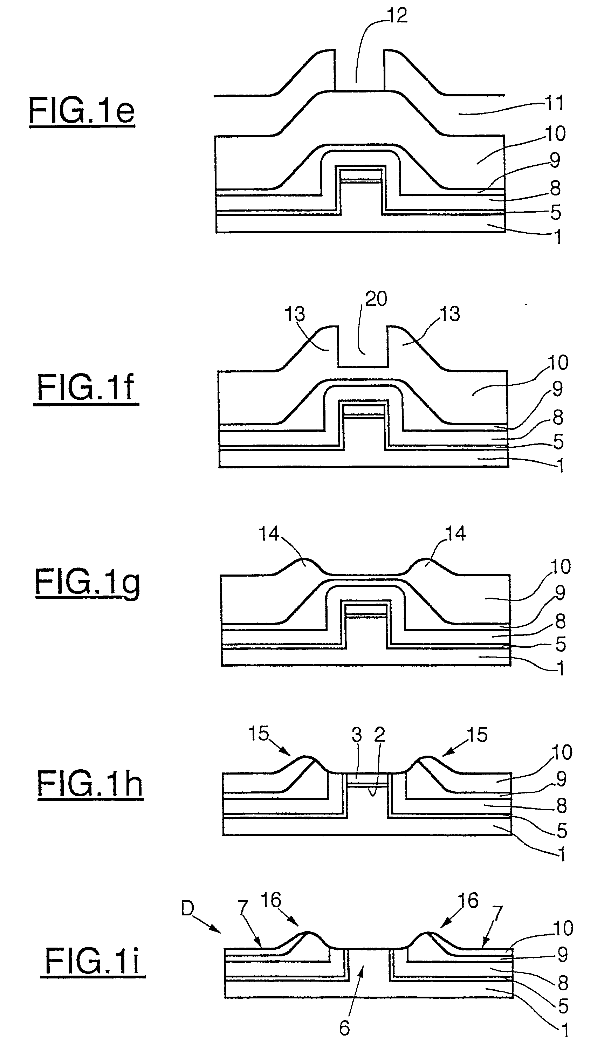

Tel qu'illustré sur les figures 1a à 1h, le mode de mise en oeuvre du procédé selon l'invention comporte tout d'abord la formation sur un substrat 1 semi-conducteur qui peut être en silicium, en arséniure de gallium ou bien du type silicium sur isolant (Silicon On Insulator), d'une couche primaire d'oxyde 2 telle que du dioxyde de silicium SiO₂ ou bien de l'oxynitrure de silicium. La formation de cette couche primaire peut être effectuée par croissance ou dépôt, et l'une de ses fonctions est de réaliser une protection du substrat 1.

Sur cette couche primaire d'oxyde 2 est déposée une couche auxiliaire, dit d'arrêt, 3 composée par exemple de silicium, polycristallin ou amorphe ou de nitrure de silicium (Si₃N₄). Comme on le verra plus en détail ci-après, cette couche auxiliaire 3 servira avantageusement de couche d'arrêt à une opération de gravure chimique des couches supérieures, avec détection de fin d'attaque. Son épaisseur est comprise entre 500 et 2000 Å, typiquement 1000 Å.

Par ailleurs, on verra également ci-après que la couche primaire d'oxyde 2 servira de couche d'arrêt pour la gravure de cette couche auxiliaire d'arrêt 3. L'épaisseur de la couche primaire d'oxyde doit être suffisante pour réaliser la fonction de couche d'arrêt et pas trop importante pour ne pas gêner les opérations de gravure. Une épaisseur convenable est comprise entre 50 Å et 500 Å.

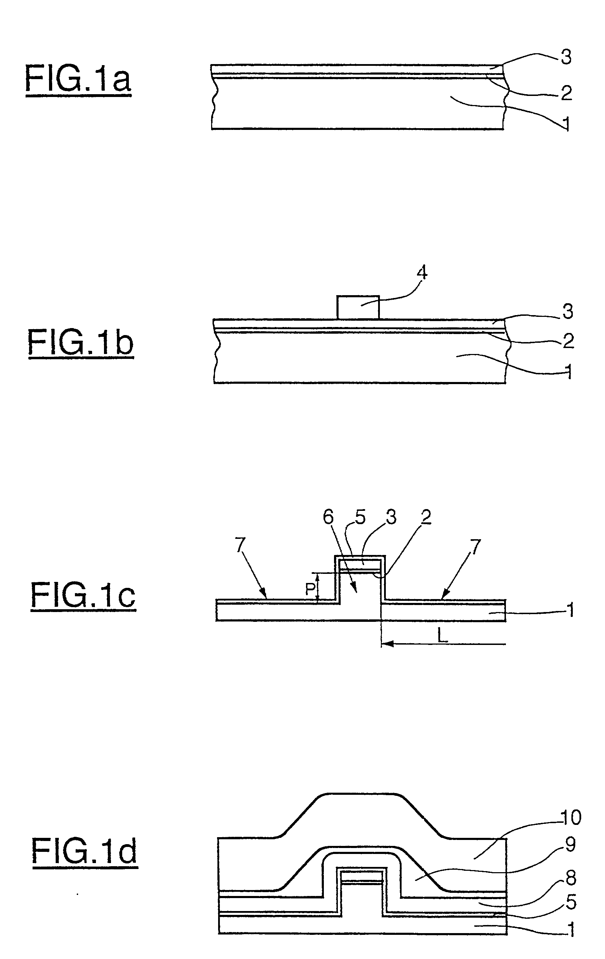

L'étape suivante consiste en la définition des régions prédéterminées de substrat destinées à former ultérieurement les zones actives du composant semi-conducteur final. Une telle étape de définition comprend classiquement un dépôt d'une résine 4 que l'on insole à travers un masque de définition des zones actives puis que l'on développe pour aboutir finalement à la structure illustrée sur la figure 1b.

Le substrat est ensuite gravé chimiquement de part et d'autre de la résine 4 puis celle-ci est retirée et l'on fait croître sur le bloc semi-conducteur une couche additionnelle d'oxyde, tel que du dioxyde de silicium, de façon à obtenir une couche 5 permettant de réaliser une bonne interface entre le substrat 1 et la future tranchée isolante 7 ainsi qu'à protéger le substrat 1 vis-à-vis des impuretés. La structure obtenue à ce stade du procédé est illustrée sur la figure 1c. La région prédéterminée de substrat, destinée à former ultérieurement les zones actives du composant semi-conducteur, est référencée 6 et est surmontée de la couche primaire d'oxyde 2 et de la couche auxiliaire 3. Les tranchées 7 sont ainsi ménagées de part et d'autre de la région 6 et sont tapissées par la couche additionnelle de dioxyde de silicium 5.

On définit alors pour ces tranchées 7 une dimension latérale, ou largeur, L et une profondeur P.

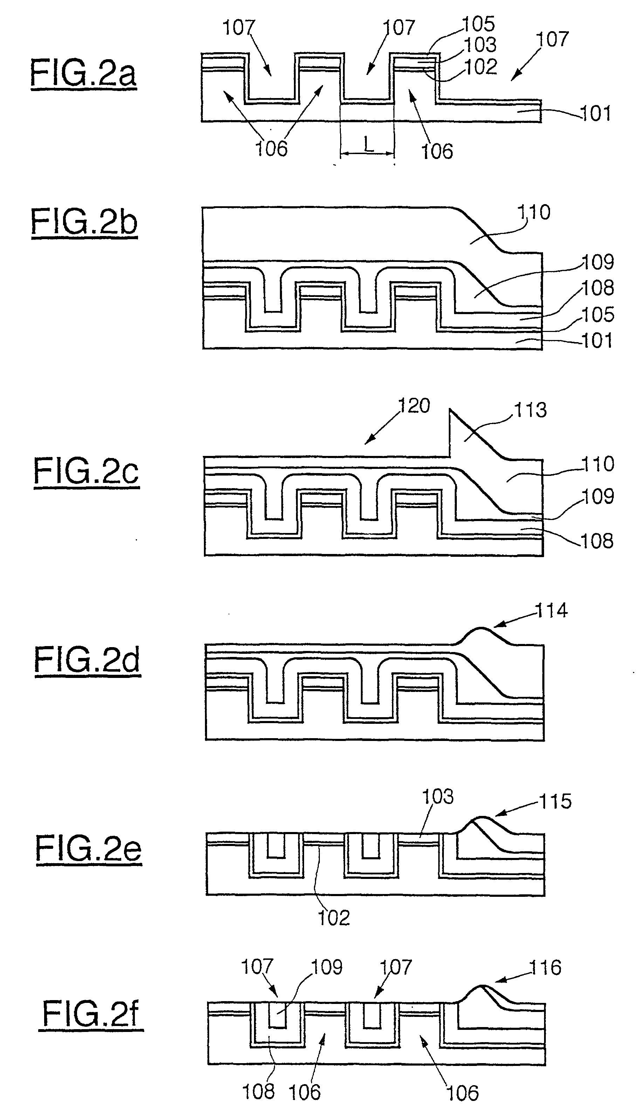

Sur une plaquette de matériau semi-conducteur, sont disposées plusieurs régions prédéterminées destinées à former ultérieurement les zones actives d'un ou plusieurs composants semiconducteurs. Les configurations géométriques de ces futures zones actives peuvent être extrêmement variées. Il peut s'agir, comme représenté sur la figure 1c, de zones actives isolées, ou bien séparées d'autres zones actives par de larges tranchées isolantes, ou bien comme illustré sur la figure 2a, de groupes de zones actives 106 mutuellement séparés par des tranchées 107 dont la largeur peut être plus ou moins étroite selon les cas.

L'étape suivante du procédé selon l'invention consiste à former dans les tranchées 7 (figure 1d) et sur la région prédéterminée de substrat (ou future zone active), un empilement isolant comportant une couche d'un premier oxyde isolant dit "d'aplanissement" 9 disposée entre deux couches 8 et 10 d'un deuxième oxyde isolant dit "conforme".

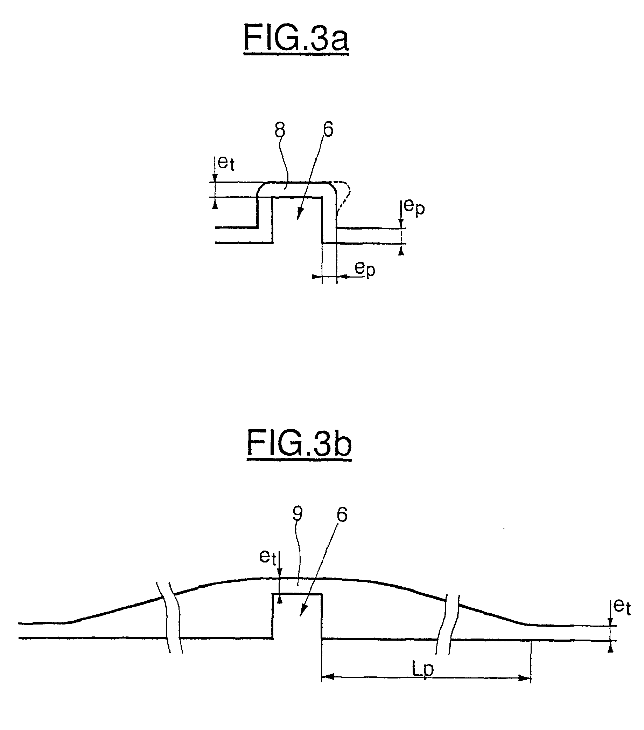

D'une façon générale, l'homme du métier sait qu'un oxyde conforme ("conformal oxide") épouse les aspérités d'un substrat sur lequel il est déposé, tandis qu'un oxyde d'aplanissement ("planarizing oxide") beaucoup plus fluide, permet notamment de boucher les petites cavités. Cette différence entre les deux oxydes peut également s'analyser au niveau de leur mobilité de surface et est illustrée plus particulièrement sur les figures 3a et 3b.

Sur la figure 3a, on a représenté une région prédéterminée 6 de substrat entourée de tranchées, et recouverte d'une couche 8 d'oxyde conforme. La mobilité de surface, quasi nulle pour l'oxyde conforme, est telle que l'épaisseur eₚ de la couche d'oxyde au pied de la marche formée par le flanc de la zone active 6, est sensiblement égale voire inférieure à l'épaisseur eₜ de cette même couche 8 à la tête de la marche, ce qui conduit à des cavités ("voids") au sein de cet oxyde conforme lorsqu'il est utilisé pour remplir des tranchées de faible largeur.

Par contre, comme illustré sur la figure 3b où la même zone active 6 a été recouverte d'une couche d'oxyde d'aplanissement 9, on voit que cette couche s'étend en pente douce de part et d'autre de la zone active pour retrouver à distance l'épaisseur eₜ de la couche mesurée au sommet de la zone active. Si Lₚ désigne la distance entre le flanc de la zone active et l'endroit où l'épaisseur de la couche retrouve la valeur eₜ, on obtient un rapport Lₚ/eₜ supérieur à 1. Par ailleurs, en raison de la pente douce de part et d'autre de la zone active, on obtient avec un oxyde d'aplanissement une surface supérieure de couche d'oxyde quasi plane plus importante que la surface supérieure de la zone active, ce qui présente un avantage dans l'utilisation de contre-masque comme expliqué plus en détail ci-après. Par exemple, il est possible d'utiliser de l'oxyde d'aplanissement fourni par la machine commercialisée par la Société britannique ELECTROTECH sous la référence "Planar 200". On obtient alors avec un tel oxyde d'aplanissement un rapport Lₚ/eₜ de l'ordre de 10.

La distinction entre l'oxyde d'aplanissement et l'oxyde conforme au sein d'un empilement peut s'effectuer par clivage de la structure empilée, au niveau d'une zone active isolée voire relativement éloignée d'une autre zone, puis par révélation chimique avec une solution chimique bien connue de l'homme du métier, par exemple à base d'acide fluorhydrique, permettant une attaque sélective des différentes couches de l'empilement et enfin par une observation au microscope électronique à balayage de façon à mesurer les épaisseurs respectives des différentes couches au pied et à la tête de la marche.

Alors que la seule utilisation d'oxyde conforme pourrait conduire dans le cas de tranchées de largeur faible, de l'ordre de 0,4 µm voire moins, avec un rapport P/L voisin de 1, à la formation de cavités dans les tranchées isolantes, l'utilisation d'oxyde d'aplanissement sur la première couche d'oxyde conforme permet de remplir parfaitement ces petites cavités.

Par ailleurs, cette première couche d'oxyde conforme 8, dont l'épaisseur est avantageusement comprise entre 1/4 et un 1/3, de préférence 1/3, de la largeur minimale des tranchées ménagées sur l'ensemble de la plaquette semi-conductrice, réalise pratiquement intégralement la fonction d'isolation électrique recherchée.

La deuxième couche d'oxyde conforme permet quant à elle de remettre quasiment à niveau la surface supérieure de l'empilement déposé dans les larges tranchées et qui présentait après dépôt de l'oxyde d'aplanissement des déclivités dues au fluage de cet oxyde sur ces grandes surfaces.

Ces deux oxydes conforme et d'aplanissement sont de même nature et peuvent être par exemple du dioxyde de silicium. Alors que l'oxyde d'aplanissement est de préférence déposé par exemple à partir de la machine Planar 200 de la Société ELECTROTECH, l'oxyde conforme peut être déposé par un dépôt CVD classique (Chemical Vapor Deposition).

L'épaisseur de la couche d'oxyde d'aplanissement est choisie de façon à ce que les tranchées de largeur minimale existant sur la plaquette soient parfaitement remplies, c'est-à-dire avec une variation de relief inférieure à 200 Å. Une épaisseur de couche d'oxyde d'aplanissement comprise entre 1000 Å et 2000 Å a été jugée satisfaisante pour des tranchées de largeur L voisine de 0,4 µm.

L'épaisseur de la deuxième couche d'oxyde conforme 10 présente une épaisseur supérieure à la somme de l'épaisseur de la couche d'arrêt 3 et de la profondeur de tranchée. Cette épaisseur de la couche 1, a été choisie supérieure de 10% à ladite somme ce qui couvre les dispersions des procédés de gravure ultérieurs.

L'étape ultérieure du procédé consiste à effectuer sur le bloc semi-conducteur ainsi formé, un recuit de densification à une température au moins égale à 900°C. Un tel recuit de densification, bien connu de l'homme du métier, permet notamment d'homogénéiser les couches d'oxyde déposées ce qui est particulièrement avantageux pour les opérations de gravure ultérieures. En outre bien qu'un tel recuit de densification soit suffisant pour obtenir des résultats d'isolations électriques satisfaisants pour le ou les composant(s) semi-conducteur(s) final(s), il s'est avéré préférable d'effectuer ce recuit de densification à une température de l'ordre de 1050° ce qui conduit une optimisation des résultats d'isolation électrique du ou des composant(s) final(s).

Les figures 1e à 1i illustrent l'étape globale d'aplanissement du bloc semi-conducteur illustré à la figure 1d.

Bien qu'il soit possible d'effectuer une telle étape globale d'aplanissement à partir d'une gravure chimique de l'empilement avec détection de fin d'attaque sur la couche auxiliaire 3, (de polysilicium par exemple) il a été observé qu'il était préférable que cette étape d'aplanissement comportât une gravure sélective partielle du bloc semi-conducteur illustré à la figure 1d, de façon à laisser subsister de part et d'autre de chaque région déterminée de substrat des zones saillantes 13 d'oxyde conforme, puis un polissage mécano-chimique partiel de la couche supérieure d'oxyde conforme du bloc semi-conducteur ainsi gravé de façon à récuire la hauteur des zones saillantes 13 d'oxyde conforme en dessous d'une hauteur de relief résiduel choisie, puis un découvrement de la région prédéterminée de substrat correspondante 6 à partir d'une gravure chimique avec détection de fin d'attaque effectuée sur le bloc semi-conducteur ayant été mécano-chimiquement poli.

Plus précisément, la définition des régions saillantes 13 s'effectue à partir d'un contre-masque correspondant au négatif du masque de définition de la zone active 6. L'utilisation de ce contre-masque fait partie d'une étape de photolithographie classique utilisant une résine 11 déposée sur la surface supérieure de la deuxième couche d'oxyde conforme 10. Après insolation à travers le contre-masque et développement de la résine, celle-ci présente dans le prolongement de la zone active 6 une cavité 12 (figure 1e).

Il convient de remarquer ici que l'utilisation combinée d'oxyde d'aplanissement et d'oxyde conforme permet d'obtenir sur la surface supérieure de la deuxième couche d'oxyde conforme, située au-dessus de la zone active 6, une portion de surface plane et suffisante pour permettre un alignement correct du contre-masque avec les bords de la zone active du substrat, compte tenu des tolérances d'alignement. On évite ainsi la formation ultérieure de petites cavités de part et d'autre de la zone active 6 du substrat et qui aurait été la conséquence des gravures chimiques réalisées ultérieurement au contre-masquage effectué sur une portion de surface trop étroite.

On effectue ensuite une gravure de la couche 10 d'oxyde conforme en temps fixe de façon à retirer une épaisseur d'oxyde égale à la somme de l'épaisseur de la couche auxiliaire 3 et de la profondeur P de la tranchée. La résine 11 est alors retirée et l'on obtient la structure illustrée sur la figure 1f. La cavité supérieure 20 du bloc ainsi formé est délimitée latéralement par les parois abruptes des pointes saillantes 13. La paroi inférieure de la cavité 20 se situe sensiblement au même niveau que la surface supérieure du bloc situé à l'extérieur des pointes 13. Par ailleurs, ces pointes 13 sont relativement étroites au pied avec une largeur au pied comprise entre 0,5 µm et 1 µm, typiquement 0,5 µm.

On effectue alors un polissage mécano-chimique partiel du bloc semi-conducteur illustré à la figure 1f de façon à adoucir les pointes saillantes 13. En d'autres termes, le polissage mécano-chimique est effectué pendant une durée telle que les hauteurs de relief résiduel des bosses 14 soient inférieures à 1000 Å typiquement. Cette limite supérieure de 1000 Å a été choisie afin d'éviter des problèmes dans les étapes ultérieures de photolithographie effectuées sur le dispositif finalement obtenu par le procédé selon l'invention (figure 1i), en vue d'obtenir les composants finals.

Ce polissage mécanochimique partiel, c'est-à-dire effectué pendant une durée laissant subsister ces bosses résiduelles, offre l'avantage d'effectuer un polissage essentiellement mécanique des régions saillantes tout en évitant une attaque essentiellement chimique des grandes zones isolantes situées de part et d'autre des régions saillantes. On évite ainsi de creuser chimiquement ces grandes zones isolantes ce qui pourrait conduire de ce fait à des dépressions dans la surface supérieure plane du dispositif semi-conducteur obtenu finalement par le procédé selon l'invention et illustré sur la figure 1i. En outre, le procédé selon l'invention permet une utilisation modérée du polissage mécano-chimique qui est une étape particulièrement délicate à mettre en oeuvre. En pratique, il s'est avéré possible d'obtenir des bosses adoucies jusqu'à une hauteur de relief résiduel de 200 Å.

L'étape suivante consiste à effectuer une gravure chimique, de préférence une gravure plasma, avec détection de fin d'attaque. Cette détection de fin d'attaque s'effectue sur la couche d'arrêt 3. A cet effet, cette couche d'arrêt 3 doit résister à la gravure plasma et doit donc être composée d'un matériau tel que le rapport de la vitesse de gravure de la couche additionnelle 5 de dioxyde de silicium sur la vitesse de gravure du matériau composant cette couche d'arrêt soit au moins supérieur à dix.

La couche d'arrêt 3 est ensuite retirée par gravure, telle qu'une gravure RIE (gravure ionique réactive) puis on procède à une désoxydation de la région prédéterminée de substrat 6 de façon à obtenir le dispositif final illustré sur la figure 1i. Ce dispositif D comporte donc la région prédéterminée de substrat 6 découverte au niveau de sa surface supérieure et qui formera ultérieurement, après implantation par exemple, la future zone active d'un composant semi-conducteur. Cette future zone active 6 est isolée des autres zones actives du substrat par des tranchées 7 comportant dans le cas présent un empilement oxyde conforme 8-oxyde d'aplanissement 9-oxyde conforme 10. Le matériau isolant de la tranchée forme par ailleurs de part et d'autre de la région prédéterminée découverte du substrat 6, une bosse 16 sur la surface supérieure plane du dispositif D. La hauteur de cette bosse est inférieure à 1000 Å ce qui ne gênera pas les étapes ultérieures éventuelles de photolithographie.

Le mode de mise en oeuvre du procédé selon l'invention qui vient d'être décrit est plus particulièrement destiné aux zones actives isolées voire relativement éloignées d'autres zones actives. Néanmoins, sur une même plaquette de substrat semi-conducteur peuvent coexister différentes configurations de zones actives ayant des formes géométriques différentes et notamment des zones actives 106 (figure 2a) mutuellement séparées par des tranchées 107 étroites, présentant par exemple des largeurs L de 0,4 µm. Les figures 2a à 2f illustrent une variante de mise en oeuvre du procédé selon l'invention plus particulièrement applicable à de telles zones actives voisines. Sur ces figures, les éléments analogues ou ayant des fonctions analogues à ceux représentés sur les figures 1a à 1i ont des références augmentées de 100 par rapport à celles qu'ils avaient sur ces figures. Seules les différences entre l'ensemble des figures 1a à 1i et 2a à 2f seront maintenant décrites.

Lorsque les variations de relief mesurées sur la couche supérieure d'oxyde conforme 110 (figure 2b) et résultant du remplissage des tranchées étroites 107 s'avèrent inférieures à une limite prédéterminée, de l'ordre de 200 Å, on considère alors que ces tranchées étroites sont parfaitement remplies. Dans ce cas, il n'est pas nécessaire de procéder à un contre-masquage individuel pour chacune de ces tranchées étroites. Le contre-masque est alors élargi par rapport au masque de définition des zones actives de façon à générer les pointes saillantes 113 de part et d'autre du groupe des futures zones actives 106 séparées par de telles tranchées étroites. Sur la figure 2c on a représenté à des fins de simplification qu'une seule de ces pointes saillantes 113.

Les étapes ultérieures du procédé sont identiques et l'on aboutit à la structure finale du dispositif D illustrée sur la figure 2f. Ceci étant, dans les tranchées étroites 107, la deuxième couche d'oxyde conforme a été complètement retirée et il ne subsiste qu'une seule couche d'oxyde conforme 108 située sous la couche d'oxyde d'aplanissement 109.

## Revendications

1. Procédé d'isolement de zones actives d'un substrat semi-conducteur par tranchées latérales, **caractérisé par le fait que** :
a) on réalise au sein du substrat semi-conducteur (1) des tranchées (7) disposées latéralement par rapport à des régions prédéterminées de substrat (6) destinées à former ultérieurement lesdites zones actives (6), certaines desdites tranchées ayant un rapport profondeur (P)/dimension latérale (L) supérieur ou égal à 1 et une dimension latérale (L) inférieure ou égale à 0,4 µm,
b) on dépose dans les tranchées (7) et sur lesdites régions prédéterminées de substrat (6) un empilement comportant une couche d'un premier oxyde isolant (9) dit d'aplanissement disposée entre deux couches (8, 10) d'un deuxième oxyde isolant dit conforme, l'épaisseur de la première couche d'oxyde conforme (8) située sous la couche d'oxyde d'aplanissement (9) étant comprise entre 1/4 et 1/3 de la dimension latérale (L) minimale des tranchées (7),
c) on effectue un recuit de densification du bloc semi-conducteur formé à l'étape b), et,
d) on effectue une étape d'aplanissement du bloc semi-conducteur recuit de façon à découvrir la surface supérieure desdites régions prédéterminées de substrat (6) et à laisser subsister dans les tranchées isolantes de l'oxyde conforme (8, 10) et de l'oxyde d'aplanissement (9)

2. Procédé selon la revendication 1, **caractérisé par le fait que** dans l'étape b) on dépose, pour former ledit empilement, la première couche d'oxyde conforme (8), puis la couche d'oxyde d'aplanissement (9) ayant une épaisseur choisie de façon à obtenir une variation de relief inférieure à un seuil prédéterminé pour les tranchées de dimension latérale minimale, et enfin, la deuxième couche d'oxyde conforme (10) ayant une épaisseur choisie en fonction de la profondeur (P) de tranchée.

3. Procédé selon la revendication 2, **caractérisé par le fait que** ledit seuil prédéterminé est choisi de l'ordre de 200 Å.

4. Procédé selon la revendication 2 ou 3, **caractérisé par le fait que** l'épaisseur de la couche d'oxyde d'aplanissement (9) est comprise entre 100 nm et 200 nm (1000 Å et 2000 Å).

5. Procédé selon l'une des revendications 2 à 4, **caractérisé par le fait que**, dans l'étape a) on effectue préalablement à la réalisation des tranchées (7) un dépôt d'une couche auxiliaire (3) sur une couche primaire isolante (2), et **par le fait que** l'épaisseur de la deuxième couche d'oxyde conforme (10) de l'empilement est choisie supérieure à la somme de l'épaisseur de ladite couche auxiliaire (3) et de la profondeur de tranchée (P).

6. Procédé selon la revendication 5, **caractérisé par le fait que** l'étape a) comporte la réalisation sur le substrat semi-conducteur de la couche primaire d'oxyde (2) avant le dépôt de la couche auxiliaire d'oxyde (3), et **par le fait que** dans l'étape (d) on retire la couche auxiliaire (3) et la couche primaire (2) après une gravure chimique.

7. Procédé selon l'une des revendications précédentes, **caractérisé par le fait que** le recuit de densification est effectué à une température de l'ordre de 1050°C.

8. Procédé selon l'une des revendications précédentes, **caractérisé par le fait que** certaines des tranchées formées ont une dimension latérale comprise entre 0,2 µm et 0,4 µm et un rapport profondeur/dimension latérale de l'ordre de 1.

## Patentansprüche

1. Verfahren zur Isolierung aktiver Zonen eines Halbleitersubstrats durch seitliche Gräben, **dadurch gekennzeichnet, dass**:
a) innerhalb des Halbleitersubstrats (1) Gräben (7) vorgesehen werden, die im Verhältnis zu vorherbestimmten Substratbereichen (6) zum späteren Bilden der aktiven Zonen (6) seitlich angeordnet sind, wobei einige der Gräben ein Verhältnis von Tiefe (P) zu Seitenabmessung (L) aufweisen, das größer oder gleich 1 ist, und eine Seitenabmessung (L), die kleiner oder gleich 0,4 µm ist,
b) in den Gräben (7) und auf den vorherbestimmten Substratbereichen (6) ein Stapel abgeschieden wird, der eine Schicht aus sogenanntem planarisierenden, isolierenden Oxid (9) umfasst, die zwischen zwei Schichten (8, 10) aus oberflächentreuem, isolierenden Oxid angeordnet ist, wobei die Dicke der ersten Schicht aus oberflächentreuem Oxid (8), die sich auf der Planarisierungsoxidschicht (9) befindet, zwischen 1/4 und 1/3 der Mindestseitenabmessung (L) der Gräben (7) liegt,
c) eine Verdichtungsglühung des in Schritt b) gebildeten Halbleiterblocks erfolgt, und
d) ein Planarisierungsschritt des geglühten Halbleiterblocks erfolgt, um die Oberseite der vorherbestimmten Substratbereiche (6) aufzudecken und in den isolierenden Gräben oberflächentreues Oxid (8, 10) und Planarisierungsoxid (9) übrig zu lassen.

2. Verfahren gemäß Anspruch 1, **dadurch gekennzeichnet, dass** in Schritt b) zum Bilden des Stapels die erste Schicht aus oberflächentreuem Oxid (8), dann die Schicht aus Planarisierungsoxid (9), die eine Dicke aufweist, die gewählt wird, um eine Reliefänderung, die kleiner ist als ein vorherbestimmter Schwellwert, für die Gräben mit der Mindestseitenabmessung zu erhalten, und schließlich die zweite Schicht aus oberflächentreuem Oxid (10), die eine Dicke aufweist, die in Abhängigkeit von der Grabentiefe (P) gewählt wird, abgeschieden wird.

3. Verfahren gemäß Anspruch 2, **dadurch gekennzeichnet, dass** der vorherbestimmte Schwellwert in der Größenordnung von 200 Å gewählt wird.

4. Verfahren gemäß Anspruch 2 oder 3, **dadurch gekennzeichnet, dass** die Dicke der Planarisierungsoxidschicht (9) zwischen 100 nm und 200 nm (1000 Ä und 2000 Å) liegt.

5. Verfahren gemäß einem der Ansprüche 2 bis 4, **dadurch gekennzeichnet, dass** in Schritt a) vor der Ausführung der Gräben (7) eine Abscheidung einer Hilfsschicht (3) auf einer isolierenden Primärschicht (2) erfolgt, und dass die Dicke der zweiten Schicht aus oberflächentreuem Oxid (10) des Stapels größer als die Summe der Hilfsschichtdicke (3) und der Grabentiefe (P) gewählt wird.

6. Verfahren gemäß Anspruch 5, **dadurch gekennzeichnet, dass** Schritt a) die Ausführung auf dem Halbleitersubstrat der Primäroxidschicht (2) vor der Abscheidung der Hilfsoxidschicht (3) umfasst, und dass in Schritt d) die Hilfsschicht (3) und die Primärschicht (2) nach einer chemischen Gravierung entfernt werden.

7. Verfahren gemäß einem der vorhergehenden Ansprüche, **dadurch gekennzeichnet, dass** die Verdichtungsglühung bei einer Temperatur in der Größenordnung von 1050 °C erfolgt.

8. Verfahren gemäß einem der vorhergehenden Ansprüche, **dadurch gekennzeichnet, dass** einige der gebildeten Gräben eine Seitenabmessung, die zwischen 0,2 µm und 0,4 µm liegt, und ein Verhältnis von Tiefe zu Seitenabmessung in der Größenordnung von 1 aufweisen.

## Claims

1. Method of isolating active zones of a semiconductor substrate using lateral trenches, **characterized in that**:
a) trenches (7) arranged laterally with respect to predetermined substrate regions (6) intended subsequently to form the said active zones (6) are produced within the semiconductor substrate (1), some of the said trenches having a depth (P)/lateral dimension (L) ratio greater than or equal to 1 and a lateral dimension (L) less than or equal to 0.4 µm,
b) a stack comprising a layer of a first isolating oxide (9), called a planarizing oxide, placed between two layers (8, 10) of a second oxide, called a conformal oxide, the thickness of the first conformal oxide layer (8) located under the planarizing oxide layer (9) being between 1/4 and 1/3 of the minimum lateral dimension (L) of the trenches (7), is deposited in the trenches (7) and on the said predetermined substrate regions (6),
c) densification annealing of the semiconductor block formed in step b) is carried out, and
d) a step of planarizing the annealed semiconductor block is carried out so as to uncover the upper surface of the said predetermined substrate regions (6) and to leave the conformal oxide (8, 10) and the planarizing oxide (9) in the isolating trenches.

2. Method according to Claim 1, **characterized in that**, in step b), the first conformal oxide layer (8), then the planarizing oxide layer (9) having a thickness chosen so as to obtain a relief variation of less than a predetermined threshold for the trenches of minimum lateral dimension, and finally, the second conformal oxide layer (10) having a thickness chosen according to the depth (P) of the trench, are deposited in order to form said stack.

3. Method according to Claim 2, **characterized in that** the said predetermined threshold is chosen to be about 200 Å.

4. Method according to Claim 2 or 3, **characterized in that** the thickness of the planarizing oxide layer (9) is between 100 nm and 200 nm (1000 Å and 2000 Å).

5. Method according to one of Claims 2 to 4, **characterized in that**, in step a), prior to producing trenches (7), an auxiliary layer (3) is deposited on a primary isolating layer (2), and **in that** the thickness of the second conformal oxide layer (10) of the stack is chosen to be greater than the sum of the thickness of the said auxiliary layer (3) and the depth of the trench (P).

6. Method according to Claim 5, **characterized in that** step a) comprises producing the primary oxide layer (2) on the semiconductor substrate before depositing the auxiliary oxide layer (3), and **in that**, in step (d), the auxiliary layer (3) and the primary layer (2) are removed after chemical etching.

7. Method according to any one of the preceding claims, **characterized in that** the densification annealing is carried out at a temperature of around 1050°C.

8. Method according to one of the preceding claims, **characterized in that** some of the trenches formed have a lateral dimension of between 0.2 µm and 0.4 µm and a depth/lateral dimension ratio of about 1.
